# EUROPEAN PATENT APPLICATION

(11) **EP 4 770 404 A1**
(43) Date of publication of application: **01.07.2026**
(21) Application number: 25214410.0
(22) Date of filing: 07.11.2025
(51) Int. Cl.: H10W 20/00, H10D 30/67, H10D 62/10, H10D 84/01, H10D 84/03, H10D 88/00, H10D 84/85, H10W 20/42, H10W 20/41, H10W 20/40

(54) **SEMICONDUCTOR DEVICE**

(30) Priority: 30.12.2024 KR 20240200868
(71) Applicant: Samsung Electronics Co., Ltd., Suwon-si, Gyeonggi-do 16677 (KR)
(72) Inventor: LEE, Kwangyoung, 16677 Suwon-si (KR); LEE, Jimyoung, 16677 Suwon-si (KR); HONG, Seki, 16677 Suwon-si (KR)
(74) Representative: Marks & Clerk LLP

(57) **Abstract**

A semiconductor device includes a gate structure extended in a first direction, perpendicular to an upper surface of a semiconductor substrate, the gate structure arranged in a second direction, parallel to the upper surface, the gate structure extended in a third direction, parallel to the upper surface and perpendicular to the second direction, active regions disposed on both sides of the gate structure in the second direction, and a plurality of gate interconnection lines electrically connected to the gate structure. The plurality of gate interconnection lines include an upper gate interconnection line and a lower gate interconnection line disposed at different heights in the first direction, and the semiconductor substrate is disposed between the upper gate interconnection line and the lower gate interconnection line in the first direction.

## Description

### BACKGROUND

A semiconductor device may include a plurality of semiconductor elements formed on a semiconductor substrate, and a plurality of interconnection lines connected to at least a portion of the plurality of semiconductor elements. The plurality of semiconductor elements may include P-channel Metal-Oxide-Semiconductor (PMOS) transistors and N-channel Metal-Oxide-Semiconductor (NMOS) transistors formed in well regions having different conductivity-types.

### SUMMARY

In general, the present disclosure is directed toward a semiconductor device capable of minimizing a difference in characteristics of semiconductor elements sharing a single gate structure by connecting an upper interconnection line and a lower gate interconnection line to both sides of a gate structure, in a direction, perpendicular to a semiconductor substrate. To enhance a degree of integration of semiconductor devices, the semiconductor devices may have a structure in which two or more semiconductor elements are stacked and arranged in a direction that is perpendicular to an upper surface of a semiconductor substrate. Depending on the circuit being implemented, the semiconductor elements stacked in the direction that is perpendicular to the upper surface of the semiconductor substrate may share a single gate structure. Implementations of the present disclosure addresses misalignment between operation timings of semiconductor elements sharing the gate structure.

According to some implementations, the present disclosure is directed to a semiconductor device that includes a gate structure extended in a first direction, perpendicular to an upper surface of a semiconductor substrate, first active regions disposed on both sides of the gate structure in a second direction, parallel to the upper surface of the semiconductor substrate, the first active regions disposed at a first height in the first direction, at least one first channel structure extended in the second direction, the at least one first channel structure buried in (e.g. passing through) the gate structure and connected to the first active regions in the second direction, second active regions disposed on both sides of the gate structure in the second direction, the second active regions disposed at a second height, different from the first height, in the first direction, at least one second channel structure extended in the second direction, the at least one second channel structure buried in (e.g. passing through) in the gate structure and connected to the second active regions in the second direction, an upper gate interconnection line disposed above the gate structure in the first direction, the upper gate interconnection line electrically connected to the gate structure, the upper gate interconnection line extended in a third direction, intersecting the second direction and parallel to the upper surface of the semiconductor substrate, and a lower gate interconnection line disposed below the gate structure in the first direction, the lower gate interconnection line electrically connected to the gate structure, the lower gate interconnection line extended in the third direction.

According to some implementations, the present disclosure is directed to a semiconductor device that includes a gate structure disposed on an upper surface of a semiconductor substrate, the gate structure extending in a first direction, perpendicular to the upper surface, a plurality of active regions disposed on both sides of the gate structure in a second direction, parallel to the upper surface, an upper gate contact disposed on the gate structure in the first direction and being in contact with the gate structure, a lower gate contact disposed in the semiconductor substrate and being in contact with the gate structure, an upper gate interconnection line electrically connected to the upper gate contact and extended in a third direction, intersecting the second direction and parallel to the upper surface, and a lower gate interconnection line electrically connected to the lower gate contact and extended in the third direction.

According to some implementations, the present disclosure is directed to a semiconductor device that includes a gate structure extending in a first direction, perpendicular to an upper surface of a semiconductor substrate, the gate structure arranged in a second direction, parallel to the upper surface, the gate structure extending in a third direction, parallel to the upper surface and perpendicular to the second direction, active regions disposed on both sides of the gate structure in the second direction, and a plurality of gate interconnection lines electrically connected to the gate structure. The plurality of gate interconnection lines may include an upper gate interconnection line and a lower gate interconnection line disposed at different heights in the first direction, and the semiconductor substrate may be disposed between the upper gate interconnection line and the lower gate interconnection line in the first direction.

At least some of the above and other features of the invention are set out in the claims.

### BRIEF DESCRIPTION OF DRAWINGS

Example implementations will be more clearly understood from the following detailed explanations, taken in conjunction with the accompanying drawings.
FIGS. 1 and 2 are schematic diagrams illustrating examples of semiconductor elements included in a semiconductor device according to some implementations.
FIG. 3 is a partial cross-sectional view taken along line I-I' of FIG. 1 according to some implementations.
FIG. 4 is a partial cross-sectional view taken along line II-II' of FIG. 1 according to some implementations.
FIG. 5A is a circuit diagram illustrating an example of an inverter circuit included in a semiconductor device according to some implementations.
FIG. 5B is a graph illustrating an example operation of the inverter circuit illustrated in FIG. 5A according to some implementations.
FIGS. 6 to 10 are schematic diagrams illustrating example structures of semiconductor elements for implementing the inverter circuit illustrated in FIG. 5 according to some implementations.
FIG. 11 is a schematic block diagram illustrating an example of a semiconductor device according to some implementations.
FIGS. 12 and 13 are circuit diagrams illustrating example circuits included in a semiconductor device according to some implementations.
FIGS. 14 and 15 are schematic diagrams illustrating example structures of semiconductor elements for implementing the circuit illustrated in FIG. 12 according to some implementations.
FIGS. 16 and 17 are circuit diagrams illustrating example circuits included in a semiconductor device according to some implementations.
FIGS. 18 and 19 are schematic diagrams illustrating example structures of semiconductor elements for implementing the circuit illustrated in FIG. 16 according to some implementations.

### DETAILED DESCRIPTION

Hereinafter, example implementations will be explained in detail with reference to the accompanying drawings.

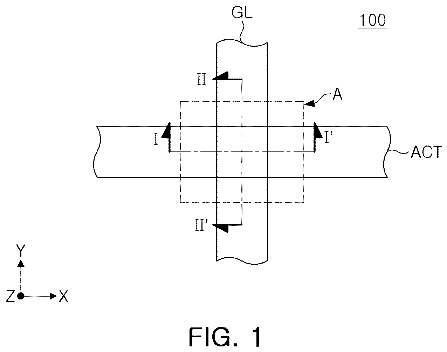

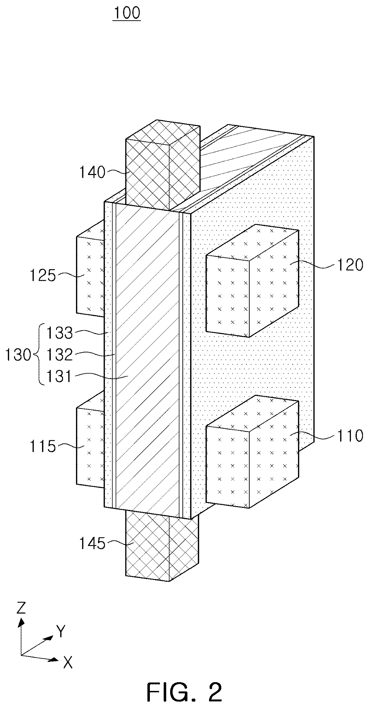

FIGS. 1 and 2 are schematic diagrams illustrating examples of semiconductor elements included in a semiconductor device according to some implementations. In FIGS. 1 and 2, a semiconductor device 100 may include semiconductor elements TR1 and TR2 stacked in a first direction (Z-axis direction). Each of the semiconductor elements TR1 and TR2 may include an active region ACT extending in a second direction (X-axis direction), and a gate line GL extending in a third direction (Y-axis direction), intersecting the second direction. The first direction (Z-axis direction) may be perpendicular to an upper surface of a semiconductor substrate. The second direction (X-axis direction) and third direction (Y-axis direction) may be parallel to the upper surface of the semiconductor substrate. The second direction and third direction may cross/intersect each other (e.g. may be perpendicular to each other). The first direction may define a height direction. For instance, a feature that is located "above" another feature may be located further along the first direction than the other feature. It will be appreciated that the directions and positions defined herein are defined relative to the structure of the semiconductor device, and therefore need not limit the orientation of the semiconductor device, in use.

FIG. 2 is a schematic perspective view of region "A" of FIG. 1 according to some implementations. In FIG. 2, certain layers (e.g. a semiconductor substrate 101, a first interlayer insulating layer 170, a second interlayer insulating layer 173, etc.) are not shown, to allow view of the semiconductor elements. In FIG. 2, a first semiconductor element TR1 and a second semiconductor element TR2 may be stacked and disposed in the first direction. One of the first semiconductor element TR1 and the second semiconductor element TR2 may be a PMOS transistor, and the other one may be an NMOS transistor. In some implementations, the first semiconductor element TR1, disposed to be relatively closer to a semiconductor substrate, may be a PMOS transistor, and the second semiconductor element TR2 may be an NMOS transistor.

The first semiconductor element TR1 may include first active regions 110 and 115 arranged in the second direction, gate structures 130 (131 to 133) disposed between the first active regions 110 and 115, and the like. The second semiconductor element TR2 may include second active regions 120 and 125 arranged in the second direction, a gate structure 130 disposed between the second active regions 120 and 125, and the like. The first active regions 110 and 115 and the second active regions 120 and 125 may be formed of different materials. The first active regions 110 and 115 and the second active regions 120 and 125 may be doped with different conductivity-types of impurities. A first type of impurity may be a p-type and a second type of impurity may be an n-type.

The first semiconductor element TR1 and the second semiconductor element TR2 may share a single gate structure 130. The gate structure 130 may include a gate electrode layer 131, a gate insulating layer 132, and a gate spacer layer 133, and the like. The gate structure layer 131 may include a conductive material, such as polysilicon, a metal, a metal compound, or the like, and the gate insulating layer 132 and the gate spacer layer 133 may include an insulating material. The gate structure 130 may extend in the first and third directions.

At least one first channel structure, extending in the second direction and connected to the first active regions 110 and 115, may be disposed between the first active regions 110 and 115, and at least one second channel structure, extending in the second direction and connected to the second active regions 120 and 125, may be disposed between the second active regions 120 and 125. The first channel structure and the second channel structure may pass through the gate structure 130 in the second direction. In some implementations, at least one of the first channel structure and the second channel structure may include a plurality of channel structures, and the plurality of channel structures may be disposed at different heights in the first direction.

The gate structure 130 may be connected to an upper gate contact 140 and a lower gate contact 145 in the first direction. The upper gate contact 140 may be in contact with an upper surface of the gate structure 130, and the lower gate contact 145 may be in contact with a lower surface of the gate structure 130. In some implementations, the lower gate contact 145 may be buried in the semiconductor substrate on which the semiconductor elements TR1 and TR2 are formed.

In FIG. 2, the gate contacts 140 and 145 may be connected to both upper and lower portions of the gate structure 130 shared by the semiconductor elements TR1 and TR2 stacked in the first direction. For an operation of a circuit including the semiconductor elements TR1 and TR2, a voltage or a signal, input to the gate structure 130, may be input in both directions through the upper gate contact 140 and the lower gate contact 145. For instance, the upper gate contact 140 and the lower gate contact 145 may be connected to the same circuitry, which may provide the voltage or signal, input to the gate structure 130. For instance, the upper gate contact 140 and lower gate contact 145 may be connected to each other (e.g. via upper and lower gate interconnection lines). Accordingly, unlike a structure in which only one of the upper gate contact 140 and the lower gate contact 145 is connected, a difference in operation timing between the first semiconductor element TR1 and the second semiconductor element TR2 caused by signal delay or the like input to the gate structure 130 may be minimized, and performance and reliability the semiconductor device 100 may be improved.

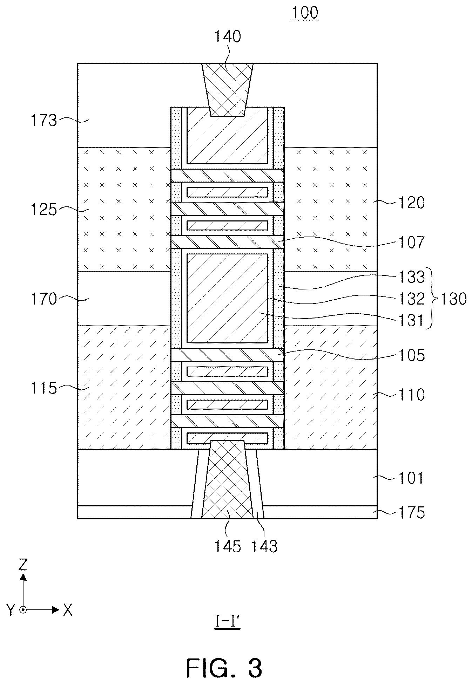

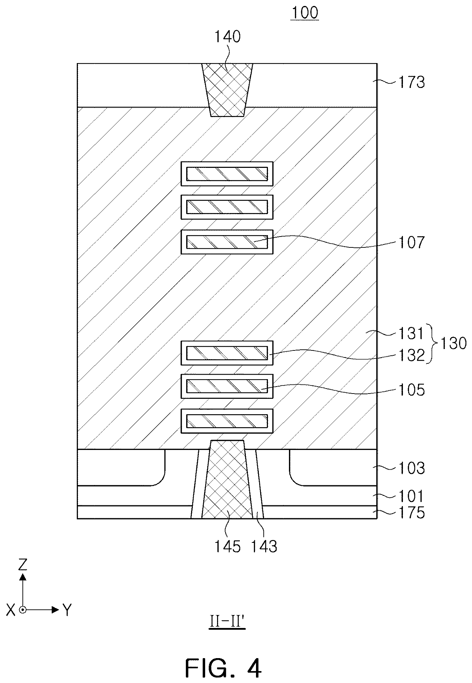

FIG. 3 is a partial cross-sectional view taken along line I-I' of FIG. 1 according to some implementations. FIG. 4 is a partial cross-sectional view taken along line II-II' of FIG. 1 according to some implementations.

In FIGS. 3 and 4, the first semiconductor element TR1 may be disposed on the semiconductor substrate 101 (e.g. on the upper surface of the semiconductor substrate 101), and the second semiconductor element TR2 may be disposed on the first semiconductor element TR1. In FIG. 4, an isolation film 103 may be formed on the semiconductor substrate 101. The isolation film may include an insulating material such as silicon oxide, and may have a shallow trench isolation (STI) structure. The first semiconductor element TR1 may not be electrically connected to (e.g. may be electrically insulated from) a semiconductor element disposed in a different position in the second direction and/or the third direction through the semiconductor substrate 101.

The first semiconductor element TR1 may include first active regions 110 and 115, a plurality of first channel structures 105 connecting the first active regions 110 and 115 to each other, the plurality of first channel structures 105 being disposed at different heights in the first direction (Z-axis direction), and a gate structure 130 (131 to 133). The second semiconductor element TR2 may include second active regions 120 and 125, a plurality of second channel structures 107 connecting the second active regions 120 and 125 to each other, the plurality of second channel structures 107 being disposed at different heights in the first direction, and a gate structure 130. Accordingly, the first semiconductor element TR1 and the second semiconductor element TR2, disposed in the same position in the second direction (X-axis direction) and the third direction (Y-axis direction) and stacked in the first direction, may share a single gate structure 130.

The gate structure 130 may include a gate electrode layer 131, a gate insulating layer 132, a gate spacer layer 133, and the like. The gate electrode layer 131 may include polysilicon, a metal, a metal compound, or the like. The gate insulating layer 132 may be disposed between the plurality of first channel structures 105 and the plurality of second channel structures 107 and the gate electrode layer 131. For example, as illustrated in FIGS. 3 and 4, the gate insulating layer 132 may be disposed to surround (e.g. in the first direction and the second direction) the plurality of first channel structures 105 and the plurality of second channel structures 107. The gate spacer layer 133 may extend in the first and third directions, and may be disposed between the gate electrode layer 131 and the active regions 110, 115, 120, and 125 in the second direction.

In the third direction, a first interlayer insulating layer 170 may be disposed between the first active regions 110 and 115 and the second active regions 120 and 125, and a second interlayer insulating layer 173 may be disposed on the second active regions 120 and 125. Each of the first interlayer insulating layer 170 and the second interlayer insulating layer 173 may include silicon oxide, silicon nitride, silicon oxynitride, or the like.

In the first direction, the upper gate contact 140 may be in contact with an upper surface of the gate electrode layer 131, and the lower gate contact 145 may be in contact with a lower surface of the gate electrode layer 131 in the first direction. The upper gate contact 140 may be disposed in a space in which at least a portion of the second interlayer insulating layer 173 is removed, and may be connected to an upper gate interconnection line or the like disposed on the second interlayer insulating layer 173. For instance, the upper gate contact 140 may penetrate at least a portion of the second interlayer insulating layer 173.

The lower gate contact 145 may pass through (e.g. may penetrate) the semiconductor substrate 101, and may be connected to the gate electrode layer 131. In the second and third directions, a contact insulating layer 143 may be disposed between the lower gate contact 145 and the semiconductor substrate 101. Thus, the lower gate contact 145 and the semiconductor substrate 101 may be electrically isolated (e.g. insulated) from each other. A third interlayer insulating layer 175 may be disposed on a lower surface of the semiconductor substrate 101. The lower surface may be opposite to the upper surface. For example, the lower gate contact 145 may extend to one surface (e.g. a lower surface) of the third interlayer insulating layer 175. The lower gate contact 145 may penetrate the substrate 101. The lower gate contact 145 may penetrate the third interlayer insulating layer 175. The lower gate contact 145 may be connected to a lower gate interconnection line disposed on the one surface (e.g. the lower surface) of the third interlayer insulating layer 175.

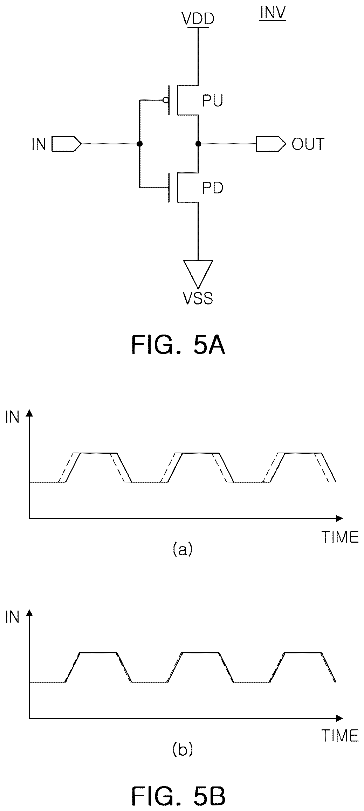

FIG. 5A is a circuit diagram illustrating an example of an inverter circuit included in a semiconductor device according to some implementations, and FIG. 5B is a graph illustrating an example operation of the inverter circuit illustrated in FIG. 5A.

In FIG. 5A, an inverter circuit INV may include a pull-up element PU and a pull-down element PD. In FIG. 5A, one pull-up element PU and one pull-down element PD are illustrated as being included in the inverter circuit INV, the number of each of the pull-up devices PU and the pull-down devices PD may vary depending on some implementations.

A first power voltage VDD may be input to a first of active regions of the pull-up element PU, for example, a source region, and an output voltage OUT may be output to the other one of the active regions (e.g. a second active region) of the pull-up element PU, for example, a drain region. Similarly, a second power voltage VSS may be input to a first active region (e.g. a source region) of the pull-down element PD, and a second active region (e.g. a drain region) of the pull-down element PD may be connected to the second active region (e.g. the drain region) of the pull-up element PU.

A gate of the pull-up element PU and a gate of the pull-down element PD may be connected to each other to receive an input voltage IN. Accordingly, as described with reference to FIG. 1 to FIG. 4, an inverter circuit INV may be implemented by semiconductor elements stacked in a direction perpendicular to an upper surface of a semiconductor substrate, the semiconductor elements sharing a single gate electrode layer, thereby reducing an area required for implementation of the inverter circuit INV and improving a degree of integration of a semiconductor device including the inverter circuit INV.

When the inverter circuit INV is implemented by assigning one of the semiconductor elements stacked on each other as the pull-up element PU and assigning the other one of the semiconductor elements as the pull-down element PD, a switching timing of the pull-up element PU and a switching timing of the pull-down element PD may be misaligned due to a difference in the transmission path of the input voltage IN applied to a gate electrode layer shared by the pull-up element PU and the pull-down element PD.

Graph (a) of FIG. 5B shows an input voltage IN applied to the pull-up element PU and an input voltage IN applied to the pull-down element PD in a structure in which only one gate contact is connected to a gate electrode layer. For example, the pull-up element PU may be a PMOS transistor, and active regions are formed of a material such as SiGe, and the pull-down element PD may be an NMOS transistor, and active regions may be formed of a material such as Si. In a direction, perpendicular to the semiconductor substrate, the pull-down element PD may be disposed on the pull-up element PU.

The pull-down element PD may be disposed on the pull-up element PU, such that one gate contact, connected to the gate electrode layer, may be disposed to be relatively closer to the pull-down element PD than the pull-up element PU. Accordingly, as illustrated in graph (a), the input voltage IN applied to the gate electrode layer through the gate contact may exhibit different swing ranges and different phases between the pull-up element PU and the pull-down element PD.

For example, a swing range of the input voltage IN applied to the pull-down element PD, relatively close to the gate contact, may be larger than a swing range of the input voltage IN applied to the pull-up element PU, relatively farther from the gate contact. In addition, a phase of the input voltage IN applied to the pull-down element PD may be relatively delayed, as compared to a phase of the input voltage IN applied to the pull-up element PU.

In some implementations, as described with reference to FIGS. 2 to 4, an upper gate contact and a lower gate contact may be connected to both sides of the gate electrode layer in a first direction, respectively. The lower gate contact may pass through the semiconductor substrate, and may be connected to the gate electrode layer. The upper gate contact and the lower gate contact may be connected in common to an application path of the input voltage IN, and the input voltage IN may be simultaneously applied to both sides of the gate electrode layer in the first direction through the upper gate contact and the lower gate contact.

Accordingly, in graph (b) of FIG. 5B, a difference between the input voltage IN applied to the pull-up element PU and the input voltage IN applied to the pull-down element PD may be reduced. In graph (b), the input voltage IN may have substantially the same swing range and phase between the pull-up element PU and the pull-down element PD, with no significant differences.

Given the above, stacked transistors may be activated at substantially the same time, avoiding timing differences. This may have applications in inverter circuits INV. Nevertheless, this is merely one potential application for the stacked semiconductor elements described herein, and embodiments may be applied to alternative circuits (e.g. involving transistors with connected gate electrodes). For instance, the arrangements described herein may be applied in logic gates, such as AND, NAND, OR and/or NOR gates.

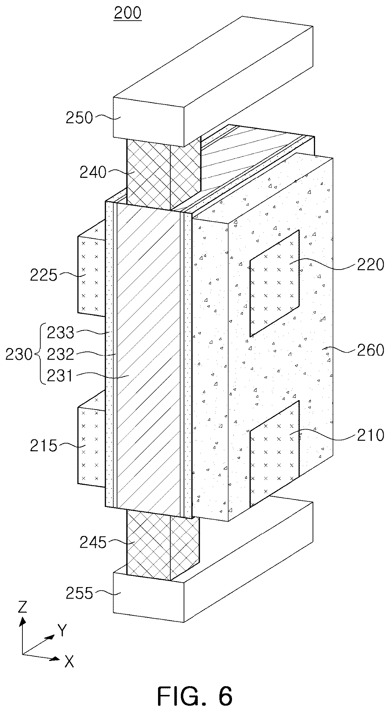

FIGS. 6 to 10 are schematic diagrams illustrating example structures of semiconductor elements for implementing the inverter circuit illustrated in FIG. 5A according to some implementations. In FIGS. 6 to 10, the semiconductor elements may be implemented in the inverter circuit illustrated in FIG. 5A. First, in FIG. 6, a semiconductor device 200 may include a first semiconductor element TR1 and a second semiconductor element TR2, stacked in the first direction (Z-axis direction). In some implementations, the first semiconductor element TR1 may be a PMOS transistor and the second semiconductor element TR2 may be an NMOS transistor, but the present disclosure is not limited thereto. For example, the first semiconductor element TR1 may be an NMOS transistor, and the second semiconductor element TR2 may be a PMOS transistor. In some implementations, the first semiconductor element TR1 and the second semiconductor element TR2 may be the same type of transistor.

In FIG. 6, the first semiconductor element TR1 may include first active regions 210 and 215 arranged in a second direction (X-axis direction), and a gate structure 230 may be disposed between the first active regions 210 and 215 in the second direction. The gate structure 230 may include a gate electrode layer 231, a gate insulating layer 232, a gate spacer layer 233, and the like, and may be disposed between the second active regions 220 and 225. The second active regions 220 and 225 may provide a source region and a drain region of the second semiconductor element TR2.

At least one first channel structure extending in the second direction, the at least one first channel structure passing through the gate structure 230, may be disposed between the first active regions 210 and 215. Similarly, at least one second channel structure extending in the second direction, the at least one second channel structure passing through the gate structure 230, may be disposed between the second active regions 220 and 225. Each of the first channel structure and the second channel structure may have a structure such as a nanosheet, a nanowire, or the like. The at least one first channel structure may comprise two or more first channel structures (e.g. arranged in the first direction). The at least one second channel structure may comprise two or more second channel structures (e.g. arranged in the first direction).

An upper gate contact 240 and a lower gate contact 245 may be connected to both sides of the gate structure 230 in the first direction. Each of the upper gate contact 240 and the lower gate contact 245 may be in direct contact with the gate electrode layer 231, the upper gate contact 240 may be connected to an upper gate interconnection line 250, and the lower gate contact 245 may be connected to a lower gate interconnection line 255. For example, the lower gate contact 245 may pass through a semiconductor substrate, and may be connected to the gate electrode layer 231, as described above with reference to FIGS. 3 and 4. The lower gate interconnection line 255 may be formed on an interlayer insulating layer disposed on a lower surface of the semiconductor substrate. Accordingly, the semiconductor substrate may be disposed between the upper gate contact 250 and the lower gate contact 255 in the first direction.

Each of the upper gate interconnection 250 and the lower gate interconnection 255 may extend in a third direction (Y-axis direction). For example, the third direction may be a direction in which the gate structure 230 extends. Each of the upper gate interconnection 250 and the lower gate interconnection 255 may provide a transmission path of an input voltage applied to an inverter circuit, and may be connected to, for example, a circuit outputting an input voltage. The upper gate interconnection 250 and the lower gate interconnection 255 may be connected in common to a single circuit outputting an input voltage, or the upper gate interconnection 250 and the lower gate interconnection 255 may be connected to circuits outputting the same input voltage, respectively.

In FIG. 6, one of the first active regions 210 and 215 and one of the second active regions 220 and 225 may be connected in common to a single active contact 260. In FIG. 6, the active contact 260 may be connected in common to one first active region 210 (e.g. a first drain region 210), among the first active regions 210 and 215, and one second active region (e.g. a second drain region 220), among the second active regions 220 and 225. Accordingly, the active contact 260 may correspond to an output node of the inverter circuit.

In FIG. 6, the active contact 260 may have an "A" shape (e.g. cross-section). In some implementations, the active contact 260 may include a first vertical region and a second vertical region in contact with the drain regions 210 and 220 in the third direction, the first vertical region and the second vertical region extending in the first direction, and a first horizontal region and a second horizontal region in contact with the drain regions 210 and 220 in the first direction, the first horizontal region and the second horizontal region extending in the third direction. The first horizontal region may be in contact with an upper surface of the second drain region 220. The second horizontal region may be positioned between the first drain region 210 and the second drain region 220. The second horizontal region may be in contact with a lower surface of the second drain region 220 and an upper surface of the first drain region 210.

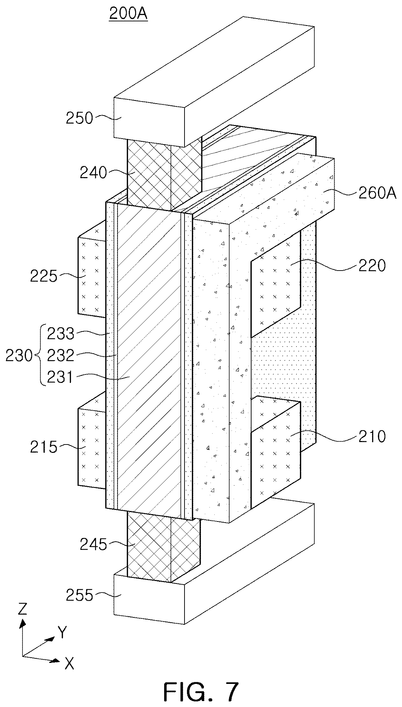

As shown in FIG. 7, a semiconductor device 200A may include a first semiconductor element TR1 and a second semiconductor element TR2 stacked in a first direction, and the first semiconductor element TR1 and the second semiconductor element TR2 may provide an inverter circuit. A gate structure 230 may be connected to an upper gate contact 250 and a lower gate contact 255 disposed on both sides thereof in a first direction.

In some implementations, a first drain region 210 of the first semiconductor element TR1 and a second drain region 220 of the second semiconductor element TR2 may be connected in common to an active contact 260A. In FIG. 7, the active contact 260A may include a first vertical region extending in the first direction, the first vertical region in contact with the drain regions 210 and 220 in a third direction, and a first horizontal region extending in the third direction, the first horizontal region in contact with the second drain region 220 in the first direction. Accordingly, as illustrated in FIG. 7, the active contact 260A may have an "L" shape (e.g. cross-section).

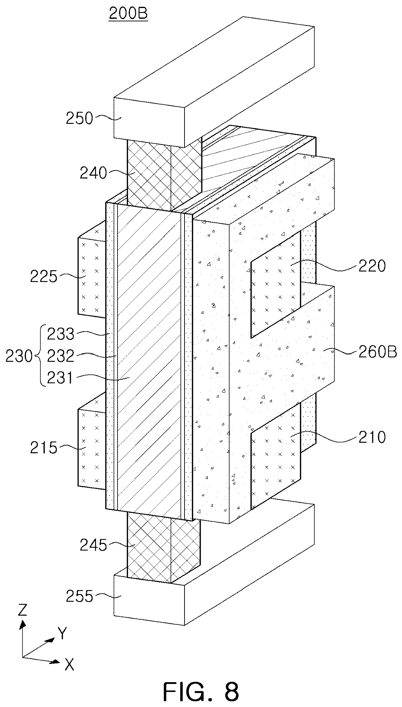

As shown in FIG. 8, a semiconductor device 200B may include a first semiconductor element TR1 and a second semiconductor element TR2 stacked in a first direction, and the first semiconductor element TR1 and the second semiconductor element TR2 may provide an inverter circuit. A gate structure 230 may be connected to an upper gate contact 250 and a lower gate contact 255 disposed on both sides thereof in a first direction.

In some implementations, a first drain region 210 of the first semiconductor element TR1 and a second drain region 220 of the second semiconductor element TR2 may be connected in common to an active contact 260B. In FIG. 8, the active contact 260B may include a first vertical region extending in the first direction, the first vertical region in contact with the drain regions 210 and 220 in a third direction, a first horizontal region extending in the third direction, the first horizontal region in contact with the second drain region 220 in the third direction, and a second horizontal region extending in the third direction, the second horizontal region in contact with the drain regions 210 and 220 in the first direction. Accordingly, as illustrated in FIG. 8, the active contact 260B may have an "F" shape (e.g. cross-section).

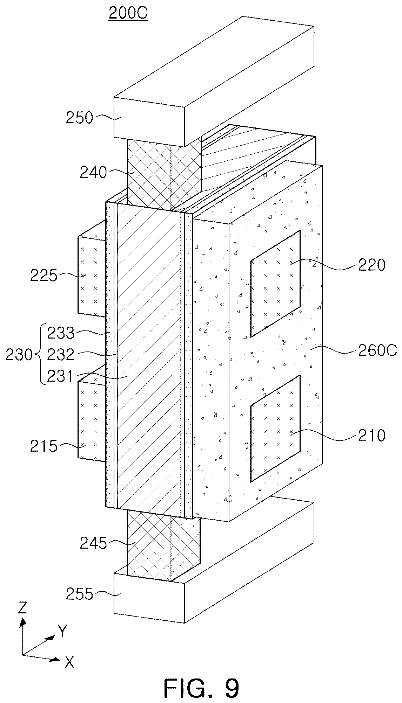

As shown in FIG. 9, a semiconductor device 200C may include a first semiconductor element TR1 and a second semiconductor element TR2 stacked in a first direction, and the first semiconductor element TR1 and the second semiconductor element TR2 may provide an inverter circuit. A gate structure 230 may be connected to an upper gate contact 250 and a lower gate contact 255 disposed on both sides thereof in a first direction.

In some implementations, a first drain region 210 of the first semiconductor element TR1 and a second drain region 220 of the second semiconductor element TR2 may be connected in common to an active contact 260C. In FIG. 9, the active contact 260C may include a first vertical region and a second vertical region extending in the first direction, the first vertical region and the second vertical region in contact with the drain regions 210 and 220 in a third direction, and first to third horizontal regions extending in the third direction, the first to third horizontal regions in contact with at least one of the drain regions 210 and 220 in the first direction. Accordingly, as illustrated in FIG. 9, the active contact 260C may have a "B" shape (e.g. cross-section).

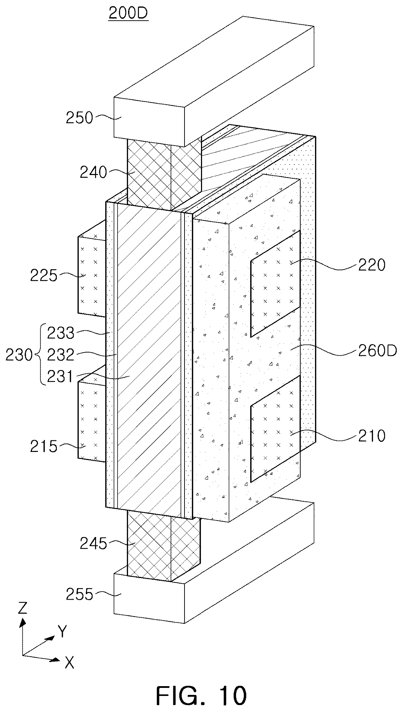

As shown in FIG. 10, a semiconductor device 200D may include a first semiconductor element TR1 and a second semiconductor element TR2 stacked in a first direction, and the first semiconductor element TR1 and the second semiconductor element TR2 may provide an inverter circuit. A gate structure 230 may be connected to the upper gate contact 250 and the lower gate contact 255 disposed on both sides thereof in a first direction.

In some implementations, a first drain region 210 of the first semiconductor element TR1 and a second drain region 220 of the second semiconductor element TR2 may be connected in common to an active contact 260C. In FIG. 10, the active contact 260D may include a first vertical region extending in the first direction, the first vertical region in contact with the drain regions 210 and 220 in a third direction, and first to third horizontal regions extending in the third direction, the first to third horizontal regions in contact with at least one of the drain regions 210 and 220 in the first direction. The first horizontal region may be in contact with an upper surface of the second drain region 220. The second horizontal region may be positioned between the first drain region 210 and the second drain region 220 and may be in contact with at least one of the first drain region 210 and the second drain region 220). The third horizontal region may be in contact with a lower surface of the first drain region 210. Accordingly, as illustrated in FIG. 10, the active contact 260D may have an "E" shape.

In some implementations, the second horizontal region, disposed between the first drain region 210 and the second drain region 220 in the first direction, may be isolated from the first drain region 210, and may be in contact with the second drain region 220. However, the present disclosure is not limited thereto. In some implementations, the second horizontal region may be in contact with the first drain region 210, and may be isolated from the second drain region 220. In some implementations, the second horizontal region may be in contact with the first drain region 210 and the second drain region 220, or may be isolated from the first drain region 210 and the second drain region 220.

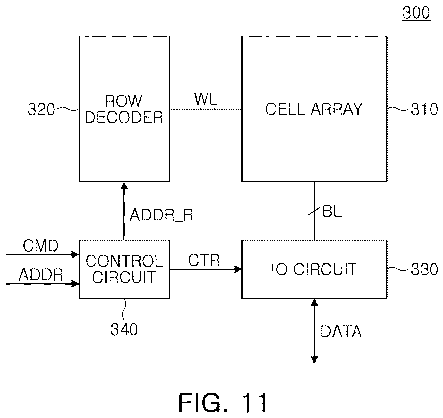

FIG. 11 is a schematic block diagram illustrating an example of a semiconductor device according to some implementations. In FIG. 11, a semiconductor device 300 include a cell array 310, a row decoder 320, an input/output circuit 330, a control circuit 340, and the like. The row decoder 320, the input/output circuit 330, and the control circuit 340 may be referred to as a peripheral circuit. In some implementations, the peripheral circuit may further include a command buffer, an address buffer, a voltage generator, and the like.

The semiconductor device 300 may receive a command CMD, an address ADDR, and data DATA. For example, the semiconductor device 300 may receive the command CMD instructing to write data, the address ADDR, and the data DATA, and may store the data DATA in a memory cell of the cell array 310 corresponding to the address ADDR. In addition, the semiconductor device 300 may receive the command CMD instructing to read data and the address ADDR, and may read the data DATA stored in the memory cell of the cell array 310 corresponding to the address ADDR and externally output the data DATA.

The cell array 310 may include a plurality of memory cells, and the plurality of memory cells may be connected to the row decoder 320 through a plurality of word lines WLs, and may be connected to the input/output circuit 330 through a plurality of bit lines BLs. In some implementations, a plurality of memory cells, included in the cell array 310, may be volatile memory cells, such as static random access memory (SRAM) cells or dynamic random access memory (DRAM) cells. In some implementations, the plurality of memory cells may be nonvolatile memory cells, such as flash memory cells or resistive random access memory (RRAM) cells.

The control circuit 340 may generate a row address ADDR_R and a control signal CTR, based on the command CMD and the address ADDR. For example, the control circuit 340 may decode the command CMD to obtain a data write command, a data read command, or the like, and may generate the row address ADDR_R and the control signal CTR to store data DATA in the cell array 310 or read data DATA from the cell array 310.

The row decoder 320 may activate at least one selected word line, among the plurality of word lines WLs, according to the row address ADDR_R. Accordingly, selected memory cells, connected to the selected word line, may be determined from among memory cells included in the cell array 310.

The input/output circuit 330 may execute a data write operation of storing the data DATA in the cell array 310 or a data read operation of reading data from the cell array 310 in response to the control signal CTR. In some implementations, the input/output circuit 330 may include a column driver. The column driver may sense a current and/or a voltage from the plurality of bit lines BLs or apply a current and/or a voltage to the plurality of bit lines BLs at a timing determined by the control signal CTR.

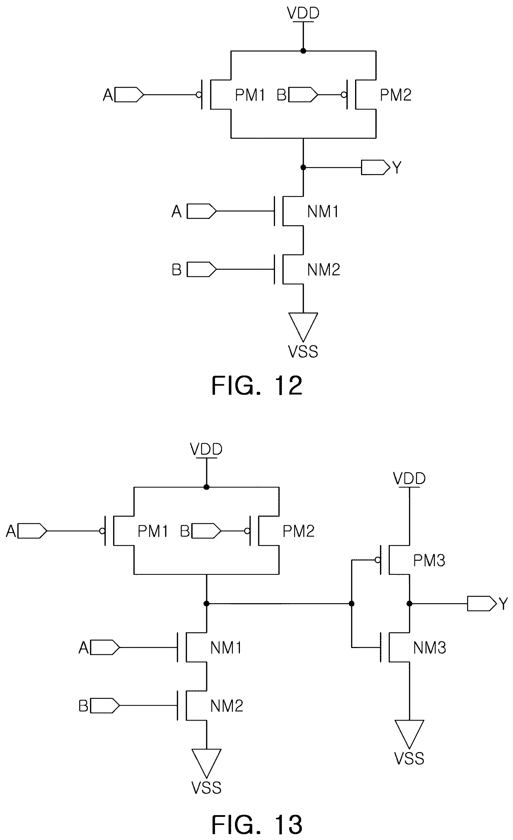

FIGS. 12 and 13 are circuit diagrams illustrating example circuits included in a semiconductor device according to some implementations. FIG. 12 may be a circuit diagram illustrating a NAND circuit included in a semiconductor device according to some implementations. In FIG. 12, the NAND circuit may include a first PMOS element PM1, a second PMOS element PM2, a first NMOS element NM1, a second NMOS element NM2, and the like. A first input signal A may be input to a gate of each of the first PMOS element PM1 and the first NMOS element NM1, and a second input signal B may be input to a gate of each of the second PMOS element PM2 and the second NMOS element NM2. An output signal Y, a NAND operation result of the first input signal A and the second input signal B, may be output from a node to which the first PMOS element PM1, the second PMOS element PM2, and the first NMOS element NM1 are connected.

When at least one of the first input signal A and the second input signal B is logic "0," at least one of the PMOS elements PM1 and PM2 may be turned on, such that the output signal Y may be set as a first power voltage VDD corresponding to logic "1." When each of the first input signal A and the second input signal B is logic "1," both the NMOS elements NM1 and NM2 may be turned on, such that the output signal Y may be set as a second power voltage VSS corresponding to logic "0."

FIG. 13 is a circuit diagram illustrating an example of an AND circuit included in a semiconductor device according to some implementations. In FIG. 13, the AND circuit may include the NAND circuit described with reference to FIG. 12, and an inverter circuit connected to the NAND circuit. The inverter circuit may include a third PMOS element PM3 and a third NMOS element NM3.

When at least one of the first input signal A and the second input signal B is logic "0," at least one of the PMOS elements PM1 and PM2 of the NAND circuit may be turned on, such that the NAND circuit may output logic "1". Logic "1" may be inverted by the inverter circuit, such that an output signal Y of the second power voltage VSS corresponding to logic "0" may be output. When each of the first input signal A and the second input signal B is logic "1", the NMOS elements NM1 and NM2 of the NAND circuit may all be turned on, such that the NAND circuit may output logic "0." Logic "0" may be inverted by the inverter circuit, such that an output signal Y of the first power voltage VDD corresponding to logic "1" may be output.

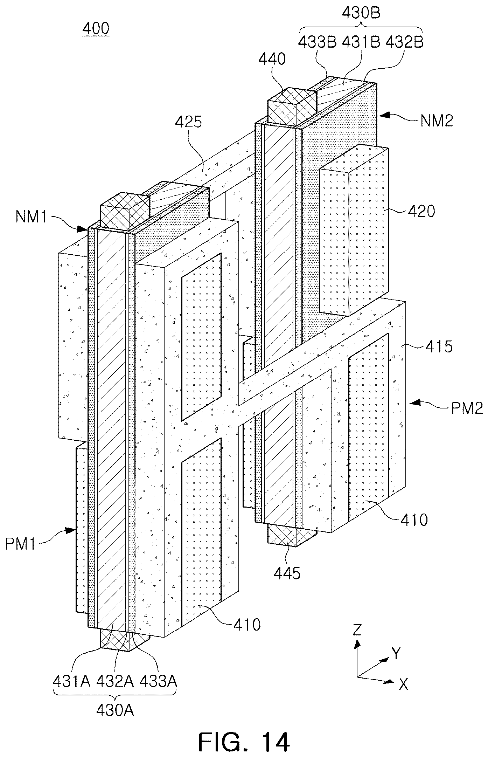

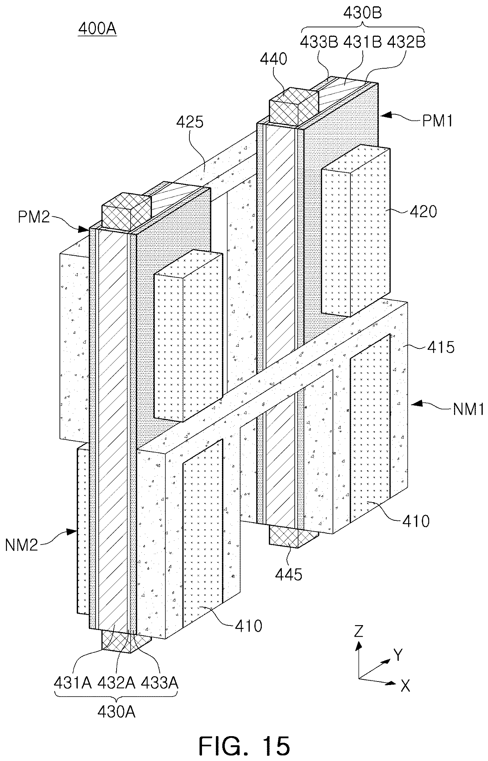

FIGS. 14 and 15 are schematic diagrams illustrating example structures of semiconductor elements for implementing the circuit illustrated in FIG. 12 according to some implementations. First, in FIG. 14, each of first and second gate structures 430A and 430B included in a semiconductor device 400 may extend in a first direction (Z-axis direction), and active regions 410 and 420 may be disposed on both sides of each of the first and second gate structures 430A and 430B in a second direction (X-axis direction). Each of the first and second gate structures 430A and 430B may include gate electrode layers 431A and 431B, gate insulating layers 432A and 432B, gate spacer layers 433A and 433B, and the like.

The active regions 410 and 420 may include first active regions 410 disposed at a first height in the first direction, and second active regions 420 disposed at a second height in the first direction. At least a portion of the active regions 410 and 420 may be connected to active contacts 415 and 425.

In FIG. 14, a first PMOS element PM1 and a first NMOS element NM1 may be provided by the first gate structure 430A and active regions 410 and 420 disposed on both sides of the first gate structure 430A. The first PMOS element PM1 and the first NMOS element NM1 may be stacked in the first direction, and may be disposed in the same position in the second direction and a third direction (Y-axis direction).

A second PMOS element PM2 and a second NMOS element NM2 may be provided by active regions 410 and 420 disposed on both sides of the second gate structure 430B and 430B. The second PMOS element PM2 and the second NMOS element NM2 may be stacked in the first direction, and may be disposed in the same position in the second direction and the third direction. The first PMOS element PM1 and the second PMOS element PM2 may be disposed in the same position in the first direction and the second direction, and may be arranged in the third direction. Similarly, the first NMOS element NM1 and the second NMOS element NM2 may be disposed in the same position in the first direction and the second direction, and may be arranged in the third direction.

The first PMOS element PM1 and the first NMOS element NM1 may share the first gate structure 430A, and a first input signal A may be input to the first gate structure 430A. The second PMOS element PM2 and the second NMOS element NM2 may share the second gate structure 430B, and a second input signal B may be input to the second gate structure 430B. The output signal Y may be output through a first active contact 415 connecting the first PMOS element PM1, the second PMOS element PM2, and the first NMOS element NM1 to each other. A second active contact 425 may provide a node at which the first NMOS element NM1 and the second NMOS element NM2 are connected to each other.

In FIG. 14, an upper gate contact 440 and a lower gate contact 445 may be connected to both sides of each of the first gate structure 430A and the second gate structure 430B in a first direction. A first input signal A may be input to the first gate structure 430A from both sides of the first gate structure 430A in the first direction, and a second input signal B may also be input to the second gate structure 430B from both sides of the second gate structure 430B in the first direction. Accordingly, as compared with a structure in which only the upper gate contact 440 is present, a difference between an operation timing of each of the PMOS elements PM1 and PM2 and an operation timing of each of the NMOS elements NM1 and NM2 may be minimized, and performance of a NAND circuit may be improved.

In FIG. 15, a NAND circuit is implemented. In FIG. 15, first and second gate structures 430A and 430B and active regions 410 and 420 included in a semiconductor device 400A may have structures similar to those described with reference to FIG. 14.

However, in FIG. 15, arrangements of the PMOS elements PM1 and PM2 and the NMOS elements NM1 and NM2 may be different from those in illustrated in FIG. 14. In FIG. 14, the PMOS elements PM1 and PM2 may be disposed below the NMOS elements NM1 and NM2 in the first direction. For example, the PMOS elements PM1 and PM2 may be disposed to be closer to a semiconductor substrate than the NMOS elements NM1 and NM2.

Conversely, in FIG. 15, the NMOS elements NM1 and NM2 may be disposed below the PMOS elements PM1 and PM2 in the first direction. Accordingly, a structure of the active contacts 415 and 425 illustrated in FIG. 15 may be different from the above structure of the active contacts 415 and 425 illustrated in FIG. 14. For example, a first active contact 415 may provide a node at which the first NMOS element NM1 and the second NMOS element NM2 are connected to each other. A second active contact 425 may connect the first PMOS element PM1, the second PMOS element PM2, and the first NMOS element NM1 to each other to provide an output node at which an output signal Y is output.

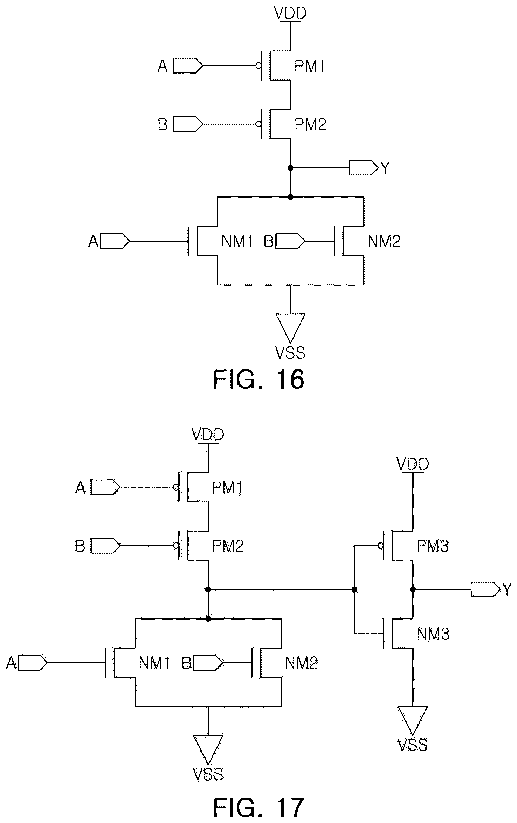

FIGS. 16 and 17 are circuit diagrams illustrating example circuits included in a semiconductor device according to some implementations. In FIG. 16, an NOR circuit may be included in a semiconductor device according to some implementations. In FIG. 16, the NOR circuit may include a first PMOS element PM1, a second PMOS element PM2, a first NMOS element NM1, a second NMOS element NM2, and the like. A first input signal A may be input to a gate of each of the first PMOS element PM1 and the first NMOS element NM1, and a second input signal B may be input to a gate of each of the second PMOS element PM2 and the second NMOS element NM2. An output signal Y, a NOR operation result of the first input signal A and the second input signal B, may be output from a node at which the second PMOS element PM2, the first NMOS element NM1, and the second NMOS element NM2 are connected to each other.

When at least one of the first input signal A and the second input signal B is logic "1," at least one of the NMOS elements NM1 and NM2 may be turned on, such that the output signal Y may be set as a second power supply voltage VSS corresponding to logic "0." When each of the first input signal A and the second input signal B is logic "0," both PMOS devices PM1 and PM2 may be turned on, such that the output signal Y may be set as a first power supply voltage VDD corresponding to logic "1."

FIG. 17 is a circuit diagram illustrating an OR circuit included in a semiconductor device according to some implementations. Referring to FIG. 17, the OR circuit may include an NOR circuit described with reference to FIG. 16, and an inverter circuit connected to the NOR circuit. The inverter circuit may include a third PMOS element PM3 and a third NMOS element NM3.

When at least one of a first input signal A and a second input signal B is logic "1," at least one of NMOS elements NM1 and NM2 of the NOR circuit may be turned on, such that the NOR circuit may output logic "0." Logic "0" may be inverted by the inverter circuit, such that an output signal Y of a first power supply voltage VDD corresponding to logic "1" may be output. When each of the first input signal A and the second input signal B is logic "0," PMOS elements PM1 and PM2 of the NOR circuit may all be turned on, such that the NOR circuit may output logic "1." Logic "1" may be inverted by the inverter circuit, such that an output signal Y of the second power supply voltage VSS corresponding to logic "0" may be output.

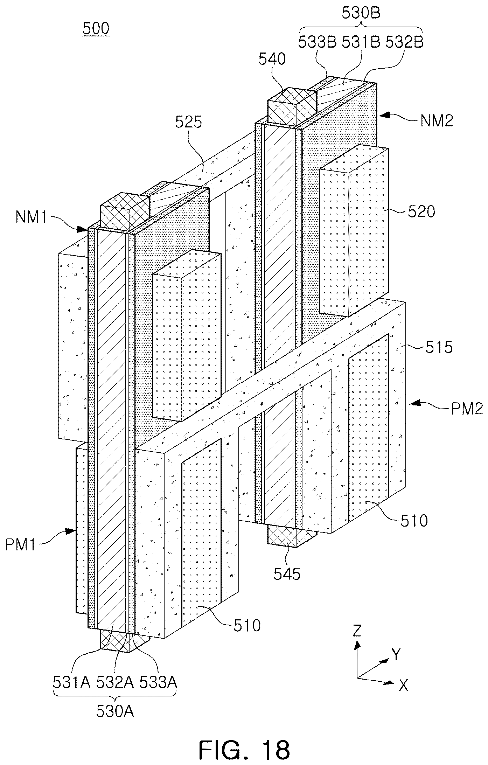

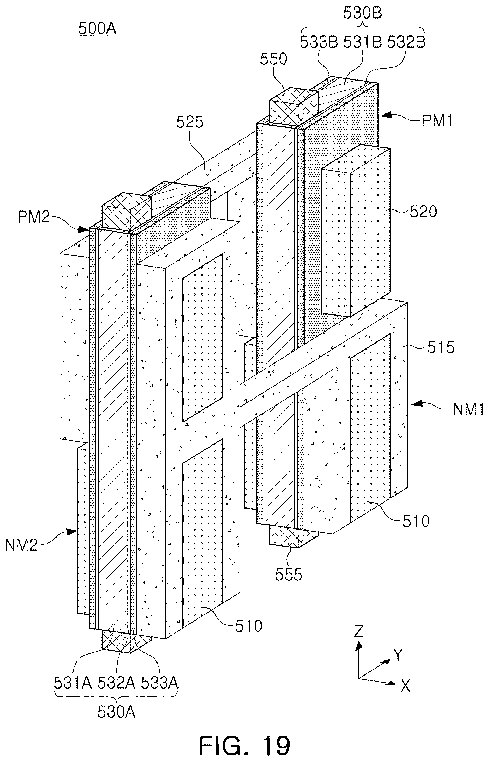

FIGS. 18 and 19 are schematic diagrams illustrating example structures of semiconductor elements for implementing the circuit illustrated in FIG. 16 according to some implementations.

First, in FIG. 18, each of first and second gate structures 530A and 530B included in the semiconductor device 500 may extend in a first direction (Z-axis direction), and active regions 510 and 520 may be disposed on both sides of each of the first and second gate structures 530A and 530B in a second direction (X-axis direction). The first and second gate structures 530A and 530B may include gate electrode layers 531A and 531B, gate insulating layers 532A and 532B, gate spacer layers 533A and 533B, and the like, respectively.

The active regions 510 and 520 may include first active regions 510 disposed at a first height in the first direction, and second active regions 520 disposed at a second height in the first direction. At least a portion of the active regions 510 and 520 may be connected to active contacts 515 and 525.

In FIG. 18, a first PMOS element PM1 and a first NMOS element NM1 may be provided by a first gate structure 530A and active regions 510 and 520 disposed on both sides of the first gate structure 530A. The first PMOS element PM1 and the first NMOS element NM1 may be stacked in the first direction, and may be disposed in the same position in the second direction and a third direction (Y-axis direction).

A second PMOS element PM2 and a second NMOS element NM2 may be provided by a second gate structure 530B and active regions 510 and 520 disposed on both sides of the second gate structure 530B. The second PMOS element PM2 and the second NMOS element NM2 may be stacked in the first direction, and may be disposed in the same position in the second direction and the third direction. The first PMOS element PM1 and the second PMOS element PM2 may be disposed in the same position in the first direction and the second direction, and may be arranged in the third direction. Similarly, the first NMOS element NM1 and the second NMOS element NM2 may be disposed in the same position in the first direction and the second direction, and may be arranged in the third direction.

The first PMOS element PM1 and the first NMOS element NM1 share the first gate structure 530A, and a first input signal A may be input to the first gate structure 530A. The second PMOS element PM2 and the second NMOS element NM2 may share the second gate structure 530B, and a second input signal B may be input to the second gate structure 530B. An output signal Y may be output through a second active contact 525 connecting the second PMOS element PM2, the first NMOS element NM2, and the second NMOS element NM2 to each other. The first active contact 515 may provide a node at which the first PMOS element PM1 and the second PMOS element PM2 are connected to each other.

In FIG. 18, an upper gate contact 540 and a lower gate contact 545 may be connected to both sides of each of the first gate structure 530A and the second gate structure 530B in the first direction. The first input signal A may be input to the first gate structure 530A from both sides of the first gate structure 530A in the first direction, and a second input signal B may also be input to the second gate structure 530B from both sides of the second gate structure 530B in the first direction. Accordingly, as compared with a structure in which only the upper gate contact 540 is present, a difference between an operation timing of each of the PMOS devices PM1 and PM2 and an operation timing of each of the NMOS elements NM1 and NM2 may be minimized, and performance of an NOR circuit may be improved.

FIG. 19 is a diagram illustrating an example implementation in which an NOR circuit is implemented. In FIG. 19, first and second gate structures 530A and 530B and active regions 510 and 520 included in a semiconductor device 500A may have structures similar to those described with reference to FIG. 18.

However, in FIG. 19, arrangements of PMOS elements PM1 and PM2 and NMOS elements NM1 and NM2 may be different from those in the implementation illustrated in FIG. 18. In FIG. 18, the PMOS elements PM1 and PM2 may be disposed below the NMOS elements NM1 and NM2 in a first direction. For example, the PMOS elements PM1 and PM2 may be disposed to be closer to a semiconductor substrate than the NMOS elements NM1 and NM2.

Conversely, in FIG. 19, the NMOS elements NM1 and NM2 may be disposed below the PMOS elements PM1 and PM2 in the first direction. Accordingly, a structure of the active contacts 515 and 525 illustrated in FIG. 19 may be different from the above structure of the active contacts 515 and 525 illustrated in FIG. 18. For example, a first active contact 515 may provide a node at which the first NMOS element NM1, the second NMOS element NM2, and the second PMOS element PM2 are connected to each other, and thus an output signal Y may be output to the first active contact 515. The second active contact 525 may provide a node at which the first PMOS element PM1 and the second PMOS element PM2 are connected to each other.

According to some implementations, semiconductor elements may be stacked in a direction, perpendicular to an upper surface of the semiconductor substrate, and two or more semiconductor elements, stacked on each other, may share a single gate structure. The gate structure, shared by the two or more semiconductor elements, may have both sides electrically connected an upper gate interconnection line and a lower gate interconnection line in the direction, perpendicular to the upper surface of the semiconductor substrate. A signal may be applied through the upper gate interconnection line and the lower gate interconnection line, thereby minimizing a difference in characteristics of the two or more semiconductor elements stacked on each other and sharing the single gate structure, and a difference in operation timing caused by signal delay.

Embodiments are set out in the following Clauses:
Clause 1. A semiconductor device comprising:
   a gate structure extended in a first direction, perpendicular to an upper surface of a semiconductor substrate;
   first active regions disposed on both sides of the gate structure in a second direction, parallel to the upper surface of the semiconductor substrate, the first active regions disposed at a first height in the first direction;
   at least one first channel structure extended in the second direction, the at least one first channel structure buried in the gate structure and connected to the first active regions in the second direction;
   second active regions disposed on both sides of the gate structure in the second direction, the second active regions disposed at a second height, different from the first height, in the first direction;
   at least one second channel structure extended in the second direction, the at least one second channel structure buried in in the gate structure and connected to the second active regions in the second direction;
   an upper gate interconnection line disposed above the gate structure in the first direction, the upper gate interconnection line electrically connected to the gate structure, the upper gate interconnection line extended in a third direction, intersecting the second direction and parallel to the upper surface of the semiconductor substrate; and
   a lower gate interconnection line disposed below the gate structure in the first direction, the lower gate interconnection line electrically connected to the gate structure, the lower gate interconnection line extended in the third direction.
Clause 2. The semiconductor device of Clause 1,
   wherein the gate structure, the first active regions, and the first channel structure provide a PMOS transistor, and
   the gate structure, the second active regions, and the second channel structure provide an NMOS transistor.
Clause 3. The semiconductor device of Clause 1 or Clause 2, further comprising:
   an upper gate contact disposed between the gate structure and the upper gate interconnection line in the first direction; and
   a lower gate contact disposed between the gate structure and the lower gate interconnection line in the first direction,
   the lower gate contact disposed in the semiconductor substrate.
Clause 4. The semiconductor device of Clause 3, further comprising:
   a contact insulating layer disposed between the lower gate contact and the semiconductor substrate in the second direction and in the third direction.
Clause 5. The semiconductor device of any preceding Clause, further comprising:
   an active contact physically connecting one first active region, among the first active regions, to one second active region, among the second active regions.
Clause 6. The semiconductor device of Clause 5, wherein the active contact includes
   a first horizontal region in contact with an upper surface of the one second active region and extended in the third direction, and
   a first vertical region in contact with a side surface of the one first active region and a side surface of the one second active region and extended in the first direction.
Clause 7. The semiconductor device of Clause 6,
   wherein the active contact further includes a second horizontal region disposed between the one first active region and the one second active region in the first direction and
   being in contact with a lower surface of the one first active region and the upper surface of the one second active region.
Clause 8. The semiconductor device of Clause 6 or Clause 7,
   wherein the active contact further includes a second vertical region extended in the first direction, and
   disposed in a position different from that of the first vertical region in the third direction, and
   wherein the second vertical region is in contact with the one first active region and the one second active region.
Clause 9. The semiconductor device of Clause 8,
   wherein the active contact further includes a second horizontal region disposed below the one second active region in the first direction and
   being in contact with a lower surface of the one second active region.
Clause 10. A semiconductor device comprising:
   a gate structure disposed on an upper surface of a semiconductor substrate, the gate structure extending in a first direction, perpendicular to the upper surface;
   a plurality of active regions disposed on both sides of the gate structure in a second direction, parallel to the upper surface;
   an upper gate contact disposed on the gate structure in the first direction and being in contact with the gate structure;
   a lower gate contact disposed in the semiconductor substrate and being in contact with the gate structure;
   an upper gate interconnection line electrically connected to the upper gate contact and extended in a third direction, intersecting the second direction and parallel to the upper surface; and
   a lower gate interconnection line electrically connected to the lower gate contact and extended in the third direction.
Clause 11. The semiconductor device of Clause 10, wherein the gate structure extends in the third direction.
Clause 12. The semiconductor device of Clause 10 or Clause 11, wherein the lower gate interconnection line is disposed above a lower surface of the semiconductor substrate opposing the upper surface.
Clause 13. The semiconductor device of any of Clauses 10-12, wherein the upper gate interconnection line and the lower gate interconnection line provide a transmission path of a signal output by a single circuit.
Clause 14. The semiconductor device of any of Clauses 10-13, wherein some active regions, among the plurality of active regions, are disposed at different heights in the first direction.
Clause 15. The semiconductor device of Clause 14, wherein the some active regions, disposed at different heights in the first direction and disposed in the same position in the second direction and the third direction, are electrically connected to each other.
Clause 16. A semiconductor device comprising:
   a gate structure extended in a first direction, perpendicular to an upper surface of a semiconductor substrate, the gate structure arranged in a second direction, parallel to the upper surface, the gate structure extended in a third direction, parallel to the upper surface and perpendicular to the second direction;
   active regions disposed on both sides of the gate structure in the second direction; and
   a plurality of gate interconnection lines electrically connected to the gate structure,
   wherein the plurality of gate interconnection lines includes an upper gate interconnection line and a lower gate interconnection line disposed at different heights in the first direction, and
   the semiconductor substrate is disposed between the upper gate interconnection line and the lower gate interconnection line in the first direction.
Clause 17. The semiconductor device of Clause 16, wherein the upper gate interconnection line and the lower gate interconnection line provide a transmission path of the same signal.
Clause 18. The semiconductor device of Clause 16 or Clause 17,
   wherein the active regions include a first active region and a second active region, disposed at different heights in the first direction, and
   the first active region is doped with a first conductivity type of impurity and the second active region is doped with a second conductivity type of impurities, different from the first conductivity type of impurity.
Clause 19. The semiconductor device of Clause 18,
   wherein the first active region includes silicon germanium, and
   the second active region includes silicon.
Clause 20. The semiconductor device of Clause 19, wherein the first active region is disposed to be closer to the upper surface than the second active region, in the first direction.
Clause 21. The semiconductor device of any preceding Clause, wherein a number of the first channel structure on both sides of the gate structure in the second direction is two or more, and wherein a number of the second channel structure on both sides of the gate structure in the second direction is two or more.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a gate structure (130) extended in a first direction perpendicular to an upper surface of a semiconductor substrate (101);
first active regions (110, 115) on both sides of the gate structure in a second direction parallel to the upper surface of the semiconductor substrate (101), the first active regions (110, 115) being disposed at a first height in the first direction;
at least one first channel structure (105) extended in the second direction, the at least one first channel structure (105) being included in the gate structure (130) and connected to the first active regions (110, 115) in the second direction;
second active regions (120, 125) on both sides of the gate structure (130) in the second direction, the second active regions (120, 125) being disposed at a second height different from the first height in the first direction;
at least one second channel structure (107) extended in the second direction, the at least one second channel structure (107) being included in the gate structure (130) and connected to the second active regions (120, 125) in the second direction;
an upper gate interconnection line (250) above the gate structure (130) in the first direction, the upper gate interconnection line (250) being electrically connected to the gate structure (130), the upper gate interconnection line (250) being extended in a third direction intersecting the second direction and parallel to the upper surface of the semiconductor substrate (101); and
a lower gate interconnection line (255) below the gate structure (130) in the first direction, the lower gate interconnection line (255) being electrically connected to the gate structure (130), the lower gate interconnection line (255) being extended in the third direction.

2. The semiconductor device of claim 1,
wherein the gate structure (130), the first active regions (110, 115), and the first channel structure (105) comprise a p-channel metal-oxide-semiconductor transistor, and
wherein the gate structure (130), the second active regions (120, 125), and the second channel structure (107) comprise an n-channel metal-oxide-semiconductor transistor.

3. The semiconductor device of claim 1 or claim 2, comprising:
an upper gate contact (140) between the gate structure (130) and the upper gate interconnection line (250) in the first direction; and
a lower gate contact (145) between the gate structure (130) and the lower gate interconnection line (255) in the first direction,
wherein the lower gate contact (145) is in the semiconductor substrate (101).

4. The semiconductor device of claim 3, comprising:
a contact insulating layer (143) between the lower gate contact (145, 245) and the semiconductor substrate (101) in the second direction and in the third direction.

5. The semiconductor device of any preceding claim, comprising:
an active contact (260) connecting one first active region (110) among the first active regions (110, 115) to one second active region (120) among the second active regions (120, 125).

6. The semiconductor device of claim 5, wherein the active contact (260) includes:
a first horizontal region in contact with an upper surface of the one second active region (120) and extended in the third direction, and
a first vertical region in contact with a side surface of the one first active region (110) and a side surface of the one second active region (220) and extended in the first direction.

7. The semiconductor device of claim 6,
wherein the active contact (250) includes a second horizontal region disposed below the one second active region (120) in the first direction, and
wherein the active contact (250) is in contact with a lower surface of the one second active region (120).

8. The semiconductor device of claim 7,
wherein the second horizontal region is between the one first active region (110) and the one second active region (120) in the first direction, and
wherein the second horizontal region contacts an upper surface of the one first active (110) region.

9. The semiconductor device of any of claims 6-8,
wherein the active contact (250) includes a second vertical region extended in the first direction,
wherein the second vertical region is in a position different from a position of the first vertical region in the third direction, and
wherein the second vertical region is in contact with the one first active region (110) and the one second active region (120).

10. The semiconductor device of any preceding claim, wherein the semiconductor substrate (101) is disposed between the upper gate interconnection line (250) and the lower gate interconnection line (255), in the first direction.

11. The semiconductor device of any preceding claim, wherein the gate structure (130) extends in the third direction.

12. The semiconductor device of any preceding claim, wherein the lower gate interconnection line (255) and the upper gate interconnection line (250) are configured to provide a transmission path of a signal output by a single circuit.

13. The semiconductor device of any preceding claim, wherein the first active regions (110, 115) are doped with a first conductivity type of impurity and the second active regions (120, 125) are doped with a second conductivity type of impurities different from the first conductivity type of impurity.

14. The semiconductor device of claim 13, wherein the first active regions (110, 115) include silicon germanium, and
wherein the second active regions (120, 125) include silicon.

15. The semiconductor device of any preceding claim, wherein a number of the at least one first channel structure (105) in the gate structure (130) is two or more, and
wherein a number of the at least one second channel structure (107) in the gate structure (130) is two or more.
